**Europäisches Patentamt**

(19) **European Patent Office**

**Office européen des brevets**

(11) Numéro de publication: **0 125 177**
**B1**

(12) **FASCICULE DE BREVET EUROPEEN**

(45) Date de publication du fascicule du brevet:
**26.08.87**

(21) Numéro de dépôt: **84400893.8**

(22) Date de dépôt: **03.05.84**

(51) Int. Cl.⁴: **H 03 H 9/205,** H 03 L 1/02,
H 03 H 3/04

(54) Oscillateur à quartz compensé en température.

(30) Priorité: **03.05.83 FR 8307308**

(43) Date de publication de la demande:
**14.11.84 Bulletin 84/46**

(45) Mention de la délivrance du brevet:
**26.08.87 Bulletin 87/35**

(84) Etats contractants désignés:
**CH DE GB LI NL SE**

(56) Documents cités:
**EP - A - 0 010 046**
**FR - A - 2 338 607**
**US - A - 3 826 931**

(73) Titulaire: **ETAT-FRANCAIS représenté par le DELEGUE GENERAL POUR L'ARMEMENT, Bureau des Brevets et Inventions de la Délégation Générale pour l'Armement 14, rue Saint-Dominique, F-75997 Paris Armées (FR)**

(72) Inventeur: **Valentin, Jean Pascal, F-25115 Pouilley Les Vignes (FR)**

ACTORUM AG

## Description

La présente invention a pour objet un oscillateur à quartz compensé en température, du type comprenant des premier et second plateaux en matériau diélectrique, disposés face à face et écartés l'un de l'autre et sur les faces internes desquels sont disposées respectivement une première et une deuxième électrode; une pastille piézoélectrique en quartz interposée entre lesdites première et deuxième électrodes sans contact avec ces dernières, taillée selon une coupe cristallographique impliquant une faible sensibilité à la température et constituant avec les première et deuxième électrodes un premier résonateur à quartz; et des moyens pour appliquer aux première et deuxième électrodes une puissance électrique d'excitation de la partie active de la pastille piézoélectrique selon un mode utile choisi pour déterminer une référence de fréquence $f_M$.

Un oscillateur à quartz de ce type utilisant un résonateur à quartz à électrodes non adhérentes au cristal a été décrit par exemple dans la demande de brevet français n° 2 338 607.

Un tel type d'oscillateur présente de nombreux avantages notamment quant à la stabilité dans le temps et la tenue mécanique. Toutefois, comme pour tous les types d'oscillateur, les variations de la température ambiante induisent des fluctuations de la fréquence de l'oscillateur dues aux variations de la température du cristal vibrant.

Pour neutraliser les effets dus aux variations de la température ambiante, qui peut évoluer sur une large gamme, par exemple $-40\,°C$ à $+85\,°C$, on est amené à placer les oscillateurs à quartz de très bonne stabilité dans les thermostats. Or, un thermostat est un accessoire volumineux, qui consomme de l'énergie, et qui entraîne un temps de mise en température qui peut atteindre une heure pour des oscillateurs pilotes et de très haute stabilité ou plusieurs dizaines de minutes pour des oscillateurs pilotes moins performants.

Il s'avère que dans le domaine des oscillateurs à quartz, on cherche de plus en plus à réaliser des appareils de volume et de masse réduits, de faible consommation, qui présentent cependant une très bonne stabilité. Dans ces conditions, il convient de rechercher des moyens autres que des thermostats, pour compenser les effets de la température ambiante sur la fréquence fournie par un oscillateur à quartz.

Des solutions ont déjà été proposées. Parmi celles-ci, la plus connue est celle qui réalise une compensation électronique de la fréquence de l'oscillateur, à l'aide d'une diode à capacité variable montée en série avec le résonateur à quartz. Dans ce type de montage d'oscillateur à cristal compensé en température dit TCXO, la capacité de la diode à capacité variable est fonction d'une tension continue V élaborée à partir d'une tension fixe, par un réseau potentiométrique composé de résistances et de thermistances. Une tension de compensation ajustable est en outre opposée à la tension délivrée par le réseau potentiométrique. Selon une variante de réalisation, la capacité variable est réalisée par modification du gain d'un amplificateur, par l'utilisation de l'effet Miller selon lequel la capacité d'entrée d'un amplificateur de gain G peut varier comme 1-G. Ce type de solution n'est pas toujours satisfaisant pour des oscillateurs de haute stabilité car la mise en œuvre d'un réseau correcteur utilisant des thermistances pour élaborer la tension de commande d'une diode à capacité variable ou faire varier le gain d'un amplificateur, est limitée par la qualité des thermistances utilisées.

Une autre solution, proposée par Donald L. HAMMOND dans le brevet des Etats-Unis d'Amérique n° 3 826 931, utilise une combinaison algébrique de fréquence dont la somme $f=f_1 + Kf_2$ présente pour une valeur choisie de la constante K un coefficient de température du premier ordre égal à zéro. Les fréquences $f_1$ et $f_2$ sont fournies par deux résonateurs piézoélectriques à double rotation taillés dans deux régions particulières d'un cristal de quartz de telle façon que les orientations spécifiques $\Phi$ et $\Theta$ de chaque résonateur dans le cristal permettent d'obtenir une annulation des coefficients de température du 2ème et du 3ème ordre dans la combinaison algébrique qui relie f à $f_1$ et $f_2$. On obtient finalement une fréquence f présentant des coefficients de température nuls pour les trois premiers ordres du développement en série de la loi fréquence-température.

Cette solution implique cependant l'utilisation de cristaux de quartz à double rotation taillés de façon très spécifique pour réaliser une compensation de l'influence de la température.

Un moyen différent pour obtenir une fréquence indépendante de la température à l'aide d'un bi-résonateur a été proposé par Raymond BESSON dans la demande de brevet européen n° 0010046. Cette solution met en œuvre un dispositif comportant deux résonateurs de même coupe cristalline mais de fréquences différentes, excités dans un système de condensateurs dont une armature est commune aux deux résonateurs. Dans la mesure où les comportements thermiques des résonateurs sont identiques, la comparaison pouvant être faite à partir des courbes fréquence-température de chaque résonateur, il est possible d'exploiter une combinaison des fréquences des deux résonateurs, cette combinaison étant une fonction simple de la température. La réalisation de deux résonateurs de même coupe cristalline et de comportements thermiques identiques peut cependant s'avérer délicate dans certains cas.

Enfin, un autre type de compensation a été proposé par John A. KUSTERS et al dans les brevets des Etats-Unis d'Amérique n° 4 079 280 et 4 160 183. Cette solution utilise un résonateur à quartz de coupe $\Phi$ 21.93° et $\Theta=33.93°$ fonctionnant simultanément sur deux modes de cisaillement d'épaisseur différents, les modes B et C. Une combinaison des deux fréquences est appliquée à un micro-processeur qui corrige l'erreur de fréquence liée à la température par l'intermédiaire d'un procédé de compensation analogique ou numérique. Une fréquence de référence est ainsi artificiellement reconstituée. Dans ce mode de compensation, on utilise un seul résonateur vibrant sur deux modes différents, de sorte qu'il peut apparaître des couplages directs entre les deux fréquences de vibration.

La présente invention vise précisément à remédier aux inconvénients précédents et à permettre de réaliser une compensation des effets de la température ambiante sur la fréquence fournie par un oscillateur à quartz, d'une manière simple, peu coûteuse et efficace qui conduise à un dispositif compact pouvant être aisément fabriqué selon les techniques connues.

Ces buts sont atteints grâce à un oscillateur à quartz du type défini en tête de la description dans lequel, conformément à l'invention, le premier plateau est constitué par un cristal de quartz taillé selon une coupe cristallographique impliquant une sensibilité à la température supérieure à celle de ladite pastille piézoélectrique en quartz, et coopère avec ladite première électrode et une troisième électrode déposée sur la face externe du premier plateau pour former un second résonateur à quartz, et qui comprend en outre des moyens pour appliquer aux première et troisième électrodes une puissance électrique d'excitation de la partie active du premier plateau selon un mode sensible à la température, à une fréquence $f_T$ dont la valeur est voisine, mais légèrement différente de la fréquence de référence $f_M$; des moyens de comparaison pour comparer les signaux présents aux bornes des deuxième et troisième électrodes et des moyens d'asservissement des moyens d'application d'une puissance électrique d'excitation de la partie active de la pastille piézoélectrique du premier résonateur en fonction du résultat de la comparaison des fréquences $f_T$ et $f_M$.

Ainsi, selon l'invention, le résonateur principal destiné à fournir une référence de fréquence peut être constitué à partir d'un cristal de quartz taillé selon une coupe classique. Quant au second résonateur, destiné à servir de capteur de température, il peut être taillé dans une partie quelconque d'un cristal de quartz et même suivant une coupe non définie, la seule obligation étant qu'il présente au moins une vibration dont la fréquence soit suffisamment sensible à la température.

La mise en œuvre d'un second résonateur n'affecte nullement la compacité du dispositif, puisque c'est l'un des plateaux supportant une électrode d'excitation qui sert lui-même de second résonateur. Cette disposition présente de plus l'avantage de placer l'élément capteur de température au plus près de la pastille piézoélectrique constituant le résonateur principal.

La pastille piézoélectrique en quartz constituant le résonateur principal est avantageusement taillée suivant la coupe cristallographique AT ($\Phi=0$, $\Theta=35°25'$).

Le plateau en quartz constituant le second résonateur peut être taillé suivant la coupe cristallographique à double rotation SC qui présente un mode de vibration très sensible à la température.

Selon un autre mode de réalisation, le plateau en quartz constituant le second résonateur est taillé suivant une coupe dégénérée proche de la coupe AT et présentant un angle $\Theta$ voisin de 35°05'. Cette coupe est assez sensible à la température et son usage, en combinaison avec une coupe AT pour le résonateur principal permet de limiter au maximum les dilatations différentielles entre le résonateur principal et le second résonateur.

Selon un mode de réalisation préférentiel, le premier plateau et la pastille piézoélectrique sont plan-convexe, la face convexe de la pastille piézoélectrique étant constituée par la face située en regard de la deuxième électrode déposée sur la face interne du second plateau, et la face convexe du premier plateau étant constituée par la face externe de ce premier plateau qui porte la troisième électrode.

Selon une caractéristique particulière, la première électrode comprend une couche métallique à faible pouvoir réflecteur et la surface de la face interne du premier plateau est rodée et non polie.

Au contraire, la troisième électrode comprend une couche d'un métal à grand pouvoir réflecteur, et la surface de la face externe du premier plateau est polie.

Par ailleurs, une quatrième électrode ne jouant pas de rôle électrique est déposée sur la face externe du second plateau diélectrique.

Avantageusement, les deuxième et quatrième électrodes sont réalisées d'une manière similaire aux première et troisième électrodes respectivement.

Ces diverses caractéristiques tendent à faciliter les échanges thermiques entre le premier et le second résonateur tout en limitant les échanges entre ces résonateurs et le milieu ambiant.

De préférence, les premier et second plateaux diélectriques sont constitués par des cristaux de quartz de même coupe cristallographique.

Ceci tend à rendre symétriques les contraintes engendrée par la dilatation différentielle entre le résonateur principal et le second résonateur.

Dans l'oscillateur selon l'invention, les moyens de comparaison pour comparer les signaux présents aux bornes des deuxième et troisième électrodes respectivement comprennent un circuit mélangeur auquel sont appliqués les signaux de fréquence $f_M$ et de fréquence $f_T$ présents respectivement sur les bornes des deuxième et troisième électrodes, et qui délibre en sortie un signal de fréquence $f_T - f_M$; un circuit diviseur de fréquence recevant les signaux de référence de fréquence $f_M$ présents sur la borne de la deuxième électrode pour fournir des signaux d'horloge à une cadence prédéterminée; et un compteur auquel sont appliqués les signaux de fréquence $f_T - f_m$ issus du circuit mélangeur et dont la base de temps est constituée par les signaux d'horloge issus du circuit diviseur.

L'oscillateur comprend des moyens de calcul d'un signal de correction fonction du type de coupe cristallographique de la pastille de quartz et de la valeur du signal issu du compteur, qui est représentative de la température du premier plateau, et des moyens pour modifier, en fonction du signal de correction, la commande des moyens d'application d'une puissance électrique d'excitation de la partie active de la pastille piézoélectrique.

De façon plus particulière, les moyens de calcul d'un signal de correction comprennent une mémoire vive munie d'une table de données donnant en sortie un nombre proportionnel à la puissance à appliquer au résonateur en fonction de la température d'entrée, la mémoire vive étant adressée par le signal issu du compteur et lesdits moyens de modification de la commande des moyens d'application d'une puissance électrique d'excitation comprennent un convertisseur numérique-analogique auquel est appliquée l'information de sortie fournie par la mémoire vive et un circuit de contrôle automatique de gain qui reçoit le signal de tension issu du convertisseur numérique-analogique et commande la puissance de fonctionnement de l'amplificateur excitateur dont la sortie est reliée à la deuxième électrode.

D'autres caractéristiques et avantages de l'invention ressortiront de la description qui fait suite d'un mode particulier de réalisation en référence au dessin annexé sur lequel:

— la figure 1 est une vue en coupe d'un résonateur principal associé à deux plateaux support d'électrodes conformément à l'invention, et

— la figure 2 représente le schéma d'un oscillateur à quartz selon l'invention utilisant le système de résonateur de la figure 1.

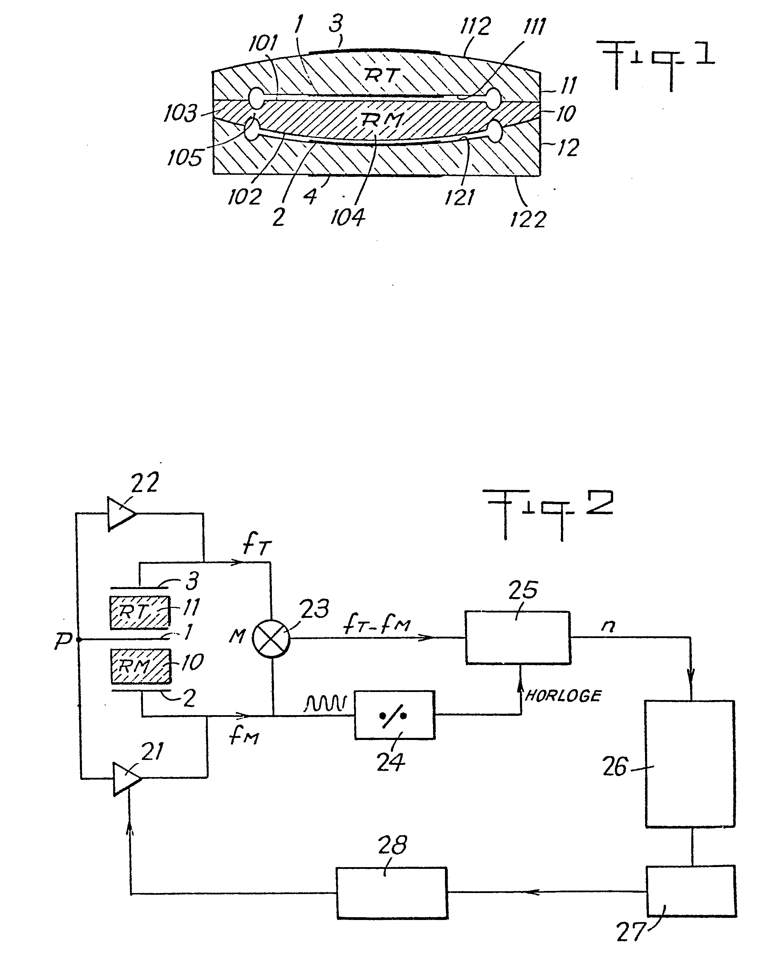

On voit sur la figure 1 la structure d'un résonateur métrologique $R_M$ à électrodes non adhérentes au cristal, réalisé de la manière décrite par exemple dans le brevet français 2 338 607. Une pastille pézoélectrique 10 comprenant une partie centrale active 104 reliée à une partie périphérique 103 par des ponts amincis 105 est interposée entre deux plateaux 11, 12 en matériau diélectrique portant chacun une électrode 1, 2 respectivement sur leur face interne 111, 121 respectivement, située en regard de la pastille piézoélectrique 10. La partie périphérique 103 de la pastille piézoélectrique 10 est montée en sandwich entre les plateaux 11 et 12 et permet l'immobilisation de la partie centrale active 104 de la pastille 10 en regard des électrodes 1,2 et à faible distance de celles-ci, la partie des faces internes 111, 121 des plateaux 11, 12 qui porte les électrodes 1, 2 étant légèrement en retrait par rapport à la partie des faces internes 111, 121 qui est en contact avec la partie périphérique 103 de la pastille 10. La partie centrale des faces opposées 101, 102 de la pastille 10 est ainsi située en regard des électrodes 1, 2, respectivement, mais sans contact avec ces dernières.

Le résonateur principal $R_M$ constitué par la pastille pézoélectrique 10 est excité à l'aide du jeu d'électrodes non adhérentes 1, 2 sur un des modes classiquement utilisés pour un résonateur métrologique, par exemple sur le mode 5 MHz, partiel 5, pour une pastille 10 taillée suivant la coupe cristallographique AT ($\Phi=0$, $\Theta=35°25'$) qui présente l'avantage de fournir une fréquence métrologique $f_M$ dépendant peu de la température.

Grâce à une adaptation très simple de la structure qui vient d'être décrite, la présente invention permet de réguler la fréquence métrologique $f_M$ afin de compenser les variations de fréquence, même faibles, qui sont provoquées par les fluctuations de la température du milieu ambiant dans lequel est placé le résonateur $R_M$.

Selon l'invention, le premier plateau 11 est réalisé de manière à constituer un second résonateur piézoélectrique fournissant une fréquence $f_T$ dépendant beaucoup de la température. Le premier plateau 11 doit ainsi être réalisé à partir d'un cristal de quartz, mais peut être taillé dans une partie quelconque d'un tel cristal et suivant une coupe non définie, la seule obligation étant qu'il présente au moins une vibration dont la fréquence soit suffisamment sensible à la température.

Le second résonateur $R_T$ est ainsi constitué par le premier plateau 11 en quartz qui coopère avec deux électrodes adhérentes 1 et 3 déposées respectivement sur la face interne et la face externe du premier plateau 11. L'électrode 1 déposée sur la face interne du premier plateau 11 est commune au résonateur principal et au second résonateur, tandis que l'électrode supplémentaire 3 ne joue un rôle que pour le second résonateur, qui est excité à l'aide du jeu d'électrodes adhérentes 1, 3 sur un mode particulièrement sensible à la température. Du fait même de sa constitution, le second résonateur, constitué par le premier plateau 11 et les électrodes 1, 3 déposées sur ce plateau, présente un vieillissement et une qualité qui sont moins bons que ceux du résonateur principal formé par la pastille de quartz 10 et les électrodes non adhérentes 1, 2. Ceci ne constitue cependant nullement un inconvénient, car la fréquence $f_T$ du second résonateur n'est pas destinée à être utilisée comme une référence de fréquence, mais simplement comme un signal donnant une information sur la température du premier plateau 11 et, par là-même, de la pastille piézoélectrique 10.

Le premier plateau piézoélectrique 11 présente une face extérieure 112 convexe et de forme sphérique afin de faciliter le piégeage de l'énergie vibratoire dans ce plateau destiné à constituer le second résonateur jouant le rôle de détecteur de température. La pastille piézoélectrique 10 est elle-même, de façon classique, plan-convexe. Par raison de symétrie, les faces planes 101, 111 de la pastille 10 et du premier plateau 11 sont situées en regard l'une de l'autre et coopèrent avec la première électrode 1, tandis que les faces convexes 102, 112 de la pastille 10 et du premier plateau 11 sont sensiblement symétriques par rapport au plan contenant la première électrode 1 et coopèrent respectivement avec la deuxième et la troisième électrode 2, 3.

Une quatrième électrode 4 est déposée sur la face externe 122 du second plateau 12 afin de garantir la symétrie des échanges thermiques par rayonnement, et réduire le gradient thermique interne du montage. Cette quatrième électrode 4 ne joue ainsi aucun rôle électrique mais, toujours pour des raisons de symétrie, peut être reliée par un fil métallique conducteur identique à ceux qui alimentent les première, deuxième et troisième électrodes 1, 2, 3, à une borne du boîtier étanche dans lequel est monté l'ensemble de la pastille 10 et des plateaux 11, 12.

Comme indiqué précédemment, les coupes cristallographiques de la pastille 10 et du premier plateau 11 sont a priori différentes. Dans ces conditions, toute variation de la température entraîne une dilatation différentielle non nulle entre la pastille 10 et le premier plateau 11. Pour rendre symétriques les contraintes engendrées par cette dilatation différentielle, on choisit le même matériau et la même coupe cristallographique pour les premier et deuxième plateaux 11, 12. Par ailleurs, les contraintes thermiques, au niveau du résonateur métrologique constitué par la pastille 10 et les électrodes 1, 2, peuvent être rendues négligeables si la partie centrale active 104 de la pastille 10 est reliée à la partie périphérique 103 par des ponts élastiques dont la localisation est fonction des axes cristallographiques du cristal.

Le second résonateur 11, qui est placé immédiatement au voisinage de la pastille de quartz 10, fournit bien une information directement liée à la température de cette pastille de quartz 10 et prend en compte aussi bien des fluctuations de la température du milieu ambiant qui atteignent la pastille de quartz 10 que des fluctuations de la température de la pastille de quartz 10 induites par un effet de chauffage interne de la partie vibrante de cette pastille de quartz 10. En effet, les échanges thermiques entre la pastille de quartz 10 et le premier plateau 11 se font essentiellement par rayonnement entre la première électrode 1 et la surface 101 de la pastille 10 qui fait face à la première électrode 1. Ces échanges thermiques sont très rapides. Pour augmenter le pouvoir émissif de la première électrode 1, on peut d'ailleurs former cette électrode par le dépôt d'une couche métallique à faible pouvoir réflecteur, réalisée par exemple en platine ou en cuivre, et la surface interne 111 du premier plateau 11 est de préférence conservée rodée et non polie. Au contraire, pour limiter au maximum l'échange par rayonnement entre le premier plateau 11 et l'extérieur, la surface extérieure de ce premier plateau 11 est soigneusement polie, et la troisième électrode 3 est formée par dépôt d'une couche mince d'un métal à grand pouvoir réflecteur tel que de l'or. Pour des raisons de symétrie thermique, la deuxième électrode 2 est réalisée d'une manière similaire à la première électrode 1 et la quatrième électrode 4 est réalisée d'une manière similaire à la troisième électrode 3.

Il a été précisé ci-dessus que le résonateur métrologique pouvait être taillé suivant une coupe AT d'angle $\Theta = 35°25'$. En effet, cette coupe est celle qui présente dans la gamme $-40$ °C, $+85$ °C, la meilleure compensation naturelle en température. C'est donc celle qui parmi toutes les coupes connues présente la plus faible variation relative de fréquence sur l'ensemble de la gamme de température citée. C'est donc aussi celle pour laquelle la correction de fréquence nécessaire sera minimale. Les courbes fréquence-température des coupes de la famille AT étant connues, on peut vérifier que la meilleure compensation est obtenue pour $\Theta = 35°25'$. Pour cette coupe, l'écart relatif de fréquence maximal est de $8.10^{-6}$ (vers $-7$ °C) et $-8.10^{-6}$ (vers 58 °C). Or la mesure de l'effet amplitude-fréquence (effet A.F.) d'une coupe AT montre qu'il s'agit d'un phénomène linéaire qui, pour un résonateur 5 MHz $P_5$ mode C se chiffre par une variation relative de fréquence positive de l'ordre de $5.10^{-6}$/mW. Pour compenser à $-7$ °C l'effet de la température sur la fréquence à l'aide de l'effet A.F., il faut diminuer la puissance d'excitation de la vibration de $8.10^{-6}/5.10^{-6} = 1,6$ mW et augmenter cette puissance de 1,6 mW à 58 °C. On choisira donc une puissance de fonctionnement à 25 °C d'environ 1,8 mW ce qui correspond à 0,2 mW à $-7$ °C et à 3,4 mW à 58 °C. Les mesures effectuées dans ce domaine de puissance ont montré que ce fonctionnement est parfaitement possible avec de faibles valeurs de vieillissement.

Toute coupe cristallographique possédant un mode sensible à la température peut être utilisée pour réaliser le premier plateau 11 constituant le second résonateur. Il suffit qu'elle présente une sensibilité moyenne de l'ordre de $2.10^{-6}$/ °C ou plus en valeur relative sur la gamme de température $-40 + 85$ °C. Bien entendu, il faut aussi que, sur toute cette gamme, la variation de la fréquence avec la température soit monotone afin d'éviter les indéterminations de température au comptage.

Dans le cas où la pastille de quartz 10 est une coupe AT, on peut, en particulier, utiliser pour les plateaux 11, 12 une coupe dégénérée proche de la coupe AT et présentant un angle $\Theta$ voisin de $35°05'$. Cette coupe s'avère posséder une sensibilité suffisante à la température, et son emploi présente l'avantage de limiter à presque zéro les dilatations différentielles entre les éléments constituant le résonateur métrologique $R_M$ et le second résonateur $R_T$.

On décrira maintenant, en référence à la figure 2, le schéma d'un oscillateur à quartz utilisant les résonateurs de la figure 1 pour effectuer automatiquement une compensation des effets dus à des variations de la température du résonateur métrologique constitué par la pastille 10 et les électrodes non adhérentes 1, 2.

Sur la figure 2, on reconnaît le résonateur principal $R_M$ composé de la pastille de quartz 10 et des premières et deuxième électrodes non adhérentes 1, 2, et le résonateur additionnel $R_T$ formé par le premier plateau en quartz 11 associé aux première et troisième électrodes 1, 3 adhérentes à ce plateau. Les circuits électroniques d'entretien des vibrations dans le résonateur principal $R_M$ et le résonateur additionnel $R_T$ comprennent des amplificateurs 21, 22, respectivement, qui présentent un point commun P correspondant à la première électrode 1 commune aux deux résonateurs $R_M$ et $R_T$. De façon classique, les résonateurs $R_M$ et $R_T$ sont placés dans les boucles de réaction des amplificateurs 21, 22.

Comme cela a été indiqué précédemment, le résonateur principal $R_M$ comprend une pastille piézoélectrique 10 taillée suivant une coupe cristallographique telle que, lorsqu'il est excité par l'amplificateur 21, il fournit une fréquence métrologique $f_M$ dépendant peu de la température. Le second résonateur $R_T$, constitué à partir du plateau de quartz 11 supportant l'une des électrodes 1 du résonateur principal $R_M$, fournit, lorsqu'il est excité par l'amplificateur 22, une fréquence $f_T$ qui, du fait du type de coupe cristallographique choisi pour le plateau 11, dépend beaucoup de la température de ce plateau 11, et donc de la pastille de quartz voisine 10. L'information de température obtenue à partir de la fréquence $f_T$ permet de commander, par l'intermédiaire de circuits de calcul, la puissance électrique appliquée au résonateur principal $R_M$ et donc, par effet amplitude-fréquence, la valeur de la fréquence métrologique $f_M$ du résonateur $R_M$. La fréquence métrologique $f_M$ peut ainsi être régulée directement à partir de l'information de température fournie par le second résonateur $R_T$. Ceci est naturellement possible du fait que la loi de variation de la fréquence de vibration d'un cristal de quartz en fonction de la température est bien connue pour une coupe cristallographique donnée de même que la relation entre l'amplitude de la vibration et la fréquence de résonance, de sorte qu'à chaque information de température, une table de valeurs enregistrée dans une mémoire ou un microprocesseur permettent de déterminer automatiquement la correction à apporter dans l'alimentation du résonateur principal $R_M$ pour compenser les variations de fréquence introduites par les variations de température.

Sur le schéma de la figure 2, on voit que les signaux de fréquence $f_M$ et $f_T$ présents sur les bornes des électrodes 2 et 3 respectivement, sont appliqués à un mélangeur 23 fournissant en sortie un signal de fréquence $f_T - f_M$ qui est appliqué à un compteur 25. Le signal de fréquence $f_M$ est par ailleurs appliqué à un circuit diviseur 24 dont la sortie fournit au compteur 25 des signaux d'horloge constituant une base de temps pour celui-ci et permettant au compteur de fournir un nombre représentatif de la différence $f_T - f_M$. A titre d'exemple, pour une fréquence $f_M$ de 5 MH$_z$, le circuit diviseur peut diviser par 500 000, afin de fournir une base de temps d'environ 0,1 s. Le nombre de coups n compté en sortie du compteur 25 permet d'adresser sur un nombre de bits prédéterminé, par exemple 11 bits, une mémoire vive 26 du type RAM qui a préalablement été garnie d'une table donnant en sortie un nombre proportionnel à la puissance à appliquer au résonateur $R_M$ en fonction de la température d'entrée. L'information numérique, par exemple sur 8 bits, fournie en sortie de la mémoire 26 est convertie en tension par le convertisseur numérique-analogique 27 dont la sortie est appliquée au circuit 28 de commande automatique de gain qui commande la puissance de fonctionnement de l'amplificateur 21.

On donnera ci-dessous un exemple de fonctionnement précis appliqué à une pastille 10 de coupe AT et utilisant une mémoire RAM courante 26 de 2 K octets à adressage sur 11 bits. Les 2048 adresses correspondront à l'information en température, ce qui, sur la gamme $-40+85$ °C entraîne des incréments de température de $125/2048 = 0,06$ °C. La courbe fréquence température de la coupe AT présente une pente maximale de $0,8.10^{-6}$/ °C. Un incrément de 0.06 °C correspond alors au maximum à une variation relative de fréquence de $0,8.10^{-6} \times 0,06 = 5.10^{-8}$. On pourrait, bien entendu, incrémenter plus finement dans les zones à pente importante et plus grossièrement lorsqu'on se rapproche des deux zones à tangente horizontale. La sortie de la mémoire étant faite sur 8 bits, on dispose de 256 informations différentes pour commander la puissance de la vibration métrologique et donc sa fréquence $f_M$ par effet amplitude-fréquence. Pour une gamme de variation relative de fréquence égale à $2 \times 8.10^{-6}$, l'incrément est de $2 \times$

$$\frac{8.10^{-6}}{256} = 6,3.10^{-8}$$ en variation relative de fréquence $\Delta f/f$, soit $6,3.10^{-8}/5.10^{-9} = 12,6$ en puissance exprimée en $\mu$W.

La stabilité de fréquence est donnée par:

$$\frac{\Delta f}{f} = 6,3.10^{-8} \text{ entre } -40 \text{ °C et } +85 \text{ °C.}$$

Ce résultat est à peu près vingt fois meilleur que celui obtenu avec un bon oscillateur à cristal compensé en température du type T.C.X.O. sur la même gamme de température.

Un exemple de valeurs des fréquences $f_T$ et $f_M$ est donné ci-dessous. En ce qui concerne la fréquence $f_M$, on peut choisir le standard classique de 5 MHz. La valeur de frequence $f_T$ dépend de la coupe utilisée pour le résonateur $R_T$. Si l'on prend la coupe SC, qui présente un mode B très sensible à la température, il est avantageux de régler le résonateur $R_T$ de façon à obtenir $f_T = 5010$ kHz à 25 °C. La sensibilité à la température du mode B 5 MHz $P_3$ d'une coupe SC est de l'ordre de $-165$ Hz/ °C et la variation est relativement linéaire. On aura donc vers 85 °C $f_T = 5000$ kHz et vers $-40$ °C $f_T = 5020$ kHz. La différence $f_T - f_M$ comprise donc entre 0 et 20 kHz fournira après comptage une information numérique n comprise entre 0 et 2000, donc bien adaptée à l'adressage d'une mémoire 26 telle que la mémoire RAM évoquée précédemment. Il faut que la précision de cette information numérique de température soit compatible avec la résolution souhaitée (incrément de température = 0,06 °C). Cette précision est liée à la sensibilité de $f_T$ à la température, soit ici en valeur relative (rapportée à la fréquence maximale du battement $f_T - f_M$): $165/20.10^{-3}$/ °C = $8,2.10^{-3}$/ °C. Or, la base de temps servant d'horloge au compteur présente la même précision relative que la fréquence $f_M$ non compensée, soit, $1,6.10^{-5}$. La précision absolue de mesure sur la température est donc donnée par:

$$1,6.10^{-5}/8,2.10^{-3} = 2/1000^{\text{ème}} \text{ de degré.}$$

Cette précision est largement suffisante pour un incrément de température de 0,06 °C. Il est clair qu'une précision nettement plus faible suffirait ici. On voit aussi qu'avec une capacité de mémoire beaucoup plus importante on peut aussi atteindre une stabilité relative de fréquence meilleure que $2.10^{-9}$ sur la gamme $-40+80$ °C.

## Revendications

1. Oscillateur à quartz compensé en température, du type comprenant des premier et second plateaux (11, 12) en matériau diélectrique, disposés face à face et écartés l'un de l'autre et sur les faces internes (111, 121) desquels sont déposés respectivement une première et une deuxième électrode (1, 2); une pastille piézoélectrique en quartz (10) interposée entre lesdites première et deuxième électrodes (1, 2) sans contact avec ces dernières, taillée selon une coupe cristallographique impliquant une faible sensibilité à la température et constituant avec les première et deuxième électrodes (1, 2) un premier résonateur à quartz (1, 10, 2); et des moyens (21) pour appliquer aux première et deuxième électrodes (1, 2) une puissance électronique d'excitation de la partie active de la pastille piézoélectrique (10) selon un mode utile choisi pour déterminer une référence de fréquence $f_M$, caractérisé en ce que le premier plateau (11) est constitué par un cristal de quartz taillé selon une coupe cristallographique impliquant une sensibilité à la température supérieure à celle de ladite pastille piézoélectrique en quartz (10), et coopère avec ladite première électrode (1) et une troisième électrode (3) déposée sur la face externe (112) du premier plateau (II) pour former un second résonateur à quartz (1, 11, 3) et en ce qu'il comprend, on outre, des moyens (22) pour appliquer aux première et troisième électrodes (1, 3) une puissance électrique d'excitation de la partie active du premier plateau (11) selon un mode sensible à la température, à une fréquence $f_T$ dont la valeur est voisine, mais légèrement différente de la fréquence de référence $f_M$; des moyens (23, 24, 25) de comparaison pour comparer les signaux présents aux bornes des deuxième et troisième électrodes (2, 3) et des moyens (24, 27, 28) d'asservissement des moyens (21) d'application d'une puissance électrique d'excitation de la partie active de la pastille piézoélectrique (10) du premier résonateur en fonction du résultat de la comparaison des fréquences $f_T$ et $f_M$.

2. Oscillateur selon la revendication 1, caractérisé en ce que le premier plateau (11) et la pastille piézoélectrique (10) sont plan-convexe, la face convexe (102) de la pastille piézoélectrique (10) étant constituée par la face située en regard de la deuxième électrode (2) déposée sur la face interne (121) du second plateau (12), et la face convexe (112) du premier plateau (11) étant constituée par la face externe (112) de ce premier plateau qui porte la troisième électrode (3).

3. Oscillateur selon la revendication 1 ou revendication 2, caractérisé en ce que les premier et second plateaux diélectriques (11, 12) sont constitués par des cristaux de quartz de même coupe cristallographique.

4. Oscillateur selon l'une quelconque des revendications 1 à 3, caractérisé en ce qu'une quatrième électrode (4) ne jouant pas de rôle électrique est déposée sur la face externe (122) du second plateau diélectrique (12).

5. Oscillateur selon l'une quelconque des revendications 1 à 4, caractérisé en ce que la pastille piézoélectrique (10) est constituée par un cristal de quartz taillé suivant la coupe cristallographie AT ($\Phi = 0$, $\Theta = 35°25'$).

6. Oscillateur selon l'une quelconque des revendications 1 à 5, caractérisé en ce que le premier plateau (11) est constitué par un cristal de quartz taillé suivant la coupe cristallographique à double rotation SC.

7. Oscillateur selon la revendication 5, caractérisé en ce que le premier plateau (11) est constitué par un cristal de quartz taillé suivant une coupe dégénérée proche de la coupe AT et présentant un angle $\Theta$ voisin de $35°05'$.

8. Oscillateur selon l'une quelconque des revendications 1 à 7, caractérisé en ce que le première électrode (1) comprend une couche métallique à faible pouvoir réflecteur et en ce que la surface de la face interne (111) du premier plateau (11) est rodée et non polie.

9. Oscillateur selon l'une quelconque des revendications 1 à 8, caractérisé en ce que la troisième électrode (3) comprend une couche d'un métal à grand pouvoir réflecteur, et en ce que la surface de la face externe (112) du premier plateau (11) est polie.

10. Oscillateur selon l'une quelconque des revendications 1 à 9, caractérisé en ce que les moyens de comparaison pour comparer les signaux présents aux bornes des deuxième et troisième électrodes (2, 3) comprennent un cricuit mélangeur (23) auquel sont appliqués les signaux de fréquence $f_M$ et de fréquence $f_T$ présents respectivement sur les bornes des deuxième et troisième électrodes (2, 3), et qui délivre en sortie un signal de fréquence $(f_T - f_M)$; un circuit diviseur de fréquence (24) recevant les signaux de référence de fréquence $f_M$ présents sur la borne de la deuxième électrode (2) pour fournier des signaux d'horloge à une cadence prédéterminée; et un compteur (25) auquel sont appliqués les signaux de fréquence $f_T - f_M$ issus du circuit mélangeur (23) et dont la base de temps est constituée par les signaux d'horloge issus du circuit diviseur (24).

11. Oscillateur selon la revendication 10, caractérisé en ce qu'il comprend des moyens de calcul d'un signal de correction fonction du type de coupe cristallographique de la pastille de quartz (10) et de la valeur du signal issu du compteur (25), qui est représentative de la température du premier plateau (11), et des moyens pour modifier, en fonction du signal de correction, la commande des moyens (21) d'application d'une puissance électrique d'excitation de la partie active de la pastille piézoélectrique (10).

12. Oscillateur selon la revendication 11, caractérisé en ce que les moyens de calcul d'un signal de correction comprennent une mémoire vive (26) munie d'une table de données donnant en sortie un nombre proportionnel à la puissance à appliquer au résonateur (10) en fonction de la température d'entrée, la mémoire vive (26) étant adressée par le signal issu du compteur (25), et en ce que lesdits moyens de modification de la commande des moyens (21) d'application d'une puissance électrique d'excitation comprennent un convertisseur numérique-analogique (27) auquel est appliquée l'information de sortie fournie par la mémoire vive (26) et un circuit de contrôle automatique de gain (28) qui reçoit le signal de tension issu du convertisseur numérique-analogique (22) et commande la puissance de fonctionnement de l'amplificateur excitateur (21) dont la sortie est reliée à la deuxième électrode (2).

## Patentansprüche

1. Quarzoszillator mit Temperaturausgleich der Bauart mit einer ersten und einer zweiten Platte (11, 12) aus dielektrischem Werkstoff, die mit Abstand einander gegenüberliegend angeordnet sind und auf deren Innenflächen (111, 112) jeweils eine erste und eine zweite Elektrode (1, 2) aufgebracht ist; mit einer zwischen die vorgenannte erste und zweite Elektrode (1, 2) ohne Kontakt mit diesen eingeschaltete piezoelektrischen Quarzscheibe (10) mit einer eine geringe Temperaturempfindlichkeit voraussetzenden Kristallorientierung, die zusammen mit der ersten und zweiten Elektrode (1, 2) einen ersten Quarzresonator (1, 10, 2) bildet; und mit Organen (21) zum Anlegen einer elektrischen Leistung an die erste und zweite Elektrode (1, 2) zwecks Erregung des aktiven Teils der piezoelektrischen Scheibe (10) gemäss einer für die Festlegung einer Bezugsfrequenz $f_M$ nützlichen Betriebsart, dadurch gekennzeichnet, dass die erste Platte (11) aus einem Quarzkristall besteht, dessen Orientierung eine Temperaturempfindlichkeit voraussetzt, die grösser ist als die der vorgenannten piezoelektrischen Quarzscheibe (10), und der mit einer ersten Elektrode (1) sowie mit einer dritten Elektrode (3) zusammenwirkt, die auf der Aussenseite (112) der ersten Platte (11) aufgebracht sind, um einen zweiten Quarzresonator (1, 11, 3) zu bilden, und dass er ferner Organe (22) zum Anlegen einer elektrischen Leistung an die erste und dritte Elektrode (1, 3) umfasst, um den aktiven Teil der ersten Platte (11) gemäss einer temperaturempfindlichen Betriebsweise auf eine Frequenz $f_T$ zu erregen, deren Wert der Bezugsfrequenz $f_M$ nahekommt, aber geringfügig von dieser abweicht; dass er weiterhin Organe (23, 24, 25) zum Vergleich der an den Klemmen der zweiten und dritten Elektrode (2, 3) anstehenden Signale sowie Organe (24, 27, 28) zur Regelung der Organe (21) zum Anlegen einer elektrischen Leistung für die Erregung des aktiven Teils der piezoelektrischen Scheibe (10) des ersten Resonators in Abhängigkeit von dem Ergebnis des Vergleichs der Frequenzen $f_T$ und $f_M$ aufweist.

2. Oszillator nach Anspruch 1, dadurch gekennzeichnet, dass die erste Platte (11) und die piezoelektrische Scheibe (10) plankonvex ausgebildet sind, wobei die konvexe Fläche (102) der Piezoscheibe (10) von der Fläche gebildet wird, die der auf der Innenfläche (121) der zweiten Platte (12) aufgebrachten zweiten Elektrode (2) gegenüberliegt, und die konvexe Fläche (112) der ersten Platte (11) von der Aussenfläche (112) dieser ersten Platte gebildet wird, welche die dritte Elektrode (3) trägt.

3. Oszillator nach Anspruch 1 oder 2, dadurch gekennzeichnet, dass die erste und zweite Platte (11, 12) aus Quarzkristallen mit derselben Orientierung bestehen.

4. Oszillator nach einem der vorstehenden Ansprüche 1 bis 3, dadurch gekennzeichnet, dass eine vierte Elektrode (4), die elektrisch keine Rolle spielt, auf der Aussenfläche (122) der zweiten dielektrischen Platte (12) aufgebracht ist.

5. Oszillator nach einem der vorstehenden Ansprüche 1 bis 4, dadurch gekennzeichnet, dass die Piezoscheibe (10) aus einem Quarzkristall besteht, der die Orientierung AT ($\Phi=0$, $\Theta 35°25'$) aufweist.

6. Oszillator nach einem der vorstehenden Ansprüche 1 bis 5, dadurch gekennzeichnet, dass die erste Platte (11) aus einem Quarzkristall besteht, der eine Doppeldrehorientierung SC aufweist.

7. Oszillator nach Anspruch 5, dadurch gekennzeichnet, dass die erste Platte (11) aus einem Quarzkristall mit einer entarteten Orientierung besteht, die der Orientierung AT nahekommt und einen Winkel $\Theta$ von etwa 35°05' aufweist.

8. Oszillator nach einem der vorstehenden Ansprüche 1 bis 7, dadurch gekennzeichnet, dass die erste Elektrode (1) eine Metallschicht mit geringem Reflexionsvermögen umfasst und dass die Oberfläche der Innenfläche (111) der ersten Platte (11) geläppt und nicht poliert ist.

9. Oszillator nach einem der vorstehenden Ansprüche 1 bis 8, dadurch gekennzeichnet, dass die dritte Elektrode (3) eine Metallschicht mit hohem Reflexionsvermögen umfasst und dass die Aussenfläche (112) der ersten Platte (11) poliert ist.

10. Oszillator nach einem der vorstehenden Ansprüche 1 bis 9, dadurch gekennzeichnet, dass die Organe zum Vergleich der an den Klemmen der zweiten und dritten Elektrode (2, 3) anstehenden Signale einen Mischkreis (23) umfassen, auf den die jeweils an den Klemmen der zweiten und dritten Elektrode (2, 3) anstehenden Signale mit der Frequenz $f_M$ und mit der Frequenz $f_T$ geführt werden und der am Ausgang ein Signal der Frequenz $(f_T - f_M)$ liefert, wobei eine Frequenzteilerschaltung (24) die an der Klemme der zweiten Elektrode (2) anstehenden Bezugssignale der Frequenz $f_M$ empfängt, um in einem vorbestimmten Rhythmus Zeitimpulse zu liefern; und dass ein Zähler (25) vorgesehen ist, dem die von dem Mischkreis (23) kommenden Signale der Frequenz $f_T - f_M$ zugeführt werden und dessen Zeitbasis von den von der Frequenzteilerschaltung (24) gelieferten Zeitimpulsen gebildet wird.

11. Oszillator nach Anspruch 10, dadurch gekennzeichnet, dass er Organe zur Berechnung eines Korrektursignals in Abhängigkeit vom Orientierungstyp der Quarzscheibe (10) und vom Wert des von dem Zähler (25) abgegebenen Signals umfasst, der für die Temperatur der ersten Platte (11) repräsentativ ist, sowie Organe zur Modifizierung der Steuerung der Organe (21) zum Anlegen einer elektrischen Leistung zur Erregung des aktiven Teils der Piezoscheibe (10) in Abhängigkeit vom Korrektursignal.

12. Oszillator nach Anspruch 11, dadurch gekennzeichnet, dass die Organe zur Berechnung eines Korrektursignals einen Lebendspeicher (26) umfassen, der mit einer Datentabelle ausgestattet ist, die am Ausgang eine Zahl liefert, welche der dem Resonator (10) in Abhängigkeit von der Eingangstemperatur zuzuführenden Leistung proportional ist, wobei der Lebendspeicher (26) von dem vom Zähler (25) kommenden Signal adressiert wird, und dass die vorgenannten Organe zur Änderung der Steuerung der Organe (21) zum Anlegen einer elektrischen Erregungsleistung einen Digital-Analog-Umsetzer (27) umfassen, auf den die von dem Lebendspeicher (26) gelieferte Ausgangsinformation gegeben wird, sowie einen Kreis (28) zur automatischen Verstärkungsregelung, der das vom Digital-Analog-Umsetzer (27) abgegebene Spannungssignal aufnimmt und die Betriebsleistung des Steuerverstärkers (21) regelt, dessen Ausgang mit der zweiten Elektrode (2) verbunden ist.

**Claims**

1. A temperature compensated quartz oscillator, comprising: first and second plates (11, 12) of dielectric matériel arranged face to face and separated from each other, with first and second electrodes (1, 2) on the inner sides (111, 121) respectively of each of said first and second plates; a piezoelectric wafer (10) of quartz having an active vibration portion located between, and spaced from, said first and second electrodes (1, 2), said quartz wafer having been cut according to a crystallographic section which has a low temperature sensitivity, said wafer and first and second electrodes (1, 2) comprising a first quartz resonator (1, 10, 2); and means (21) for applying to said first and second electrodes (1, 2) excitation electric power to drive active portion of the wafer (10) according to an operative mode thereof having a reference frequency $f_M$, wherein the first dielectric plate (11) comprises a quartz crystal cut according to a crystallographic section which has a temperature sensitivity which exceeds the sensitivity of the quartz piezoelectric wafer (10), and said first dielectric plate cooperates with said first electrode (1) and a third electrode (2), located on the outer surface (112) of the first plate (11) to form a second quartz resonator (1, 11, 3), and means (22) for applying to said first and third electrodes (1, 3) electric excitation power to drive the active portion of the first dielectric plate (11) according to a temperature-sensitive mode having a frequency $f_T$ close to, but slightly different from, the reference frequency,

$f_M$, means (23, 24, 25) for comparing signals at terminals of the second and third electrodes (2, 3), and means (24, 27, 28) for regulating the means (21) for applying an electric excitation power to drive the active portion of the piezoelectric wafer (10) of the first resonator based on the comparison of signals at the terminals of the second and third electrodes.

2. Oscillator according to claim 1, wherein the first dielectric plate (11) and the piezoelectric wafer (10) are convexo-planar, the convex side (102) of the piezoelekectric wafer (10) comprising the side facing the second electrode (2) on the inner side (121) of the second dielectric plate (12), and the convex side (112) of the first dielectric plate (11) comprising the outer side (112) of the first dielectric plate which carries the third electrode (3).

3. Oscillator according to any of claims 1 or 2, wherein the first and second dielectric plates (11, 12) comprise quartz crysals with the same crystallographic section.

4. Oscillator according to any of claims 1 to 3, additionally comprising a fourth electrode (4) which does not play an electric role, on the outer side (112) of the second dielectric plate (12).

5. Oscillator according to claims 1 to 4, wherein the piezoelectric wafer (10) comprises a quartz crystal which is cut according to the crystallographic section AT, $\Phi=0$, $\Theta=35$ degrees and 25 minutes.

6. Oscillator according to any of claims 1 to 5 wherein the first plate (11) comprises a quartz crystal which is cut according to the double rotation SC crystallographic section.

7. Oscillator of claim 5, wherein the first dielectric plate (11) comprises a crystal quartz that is cut according to a degenerate section close to section AT and displaying an angle close to 35 degrees and 5 minutes.

8. Oscillator according to any of claims 1 to 7, wherein the first electrode (1) includes a metal layer with low reflexting power, and the surface of the inner side (111) of the first dielectric plate (11) is seasoned and unpolished.

9. Oscillator according to any of claims 1 to 8 wherein the third electrode (3) includes a layer of a metal with high reflecting power, and the surface of the outher side (112) of the first dielectric plate 11 is polished.

10. Oscillator according to any of claims 1 to 9 wherein the means for comparing the signals at the terminals of the second and third electrodes (2, 3) comprises a mixer circuit (23) to which is supplied the frequency $f_M$ and frequency $f_r$ signals respectively at the terminals of the second and third electrodes (2, 3) and which issues an output frequency signal $(f_r-f_M)$; divider frequency circuit (29) which divides the reference signals with a frequency $f_M$ at the terminal of the second electrode (2) to supply clock signals at a pre-set rate; and a counter 15 to which is supplied the frequency $f_r$, $f_M$ signals from the mixer circuit and whose time base comprises the clock signals from the divider circuit (24).

11. Oscillator according to any of claim 10, further comprising means for calculating a correction function signal for the type of crystallographic section of the quartz piezoelectric wafer (10) based on the value of the signal from the counter (25), which is representative of the temperature of the first dielectric plate (11) and means for altering according to the correction signal, control of the means (21) for applying an excitation electric power to drive the active portion of the piezoelectric wafer (10).

12. Oscillator according to claim 11, wherein the means for calculating a correction signal comprises a fat memory (26) equipped with a program which feeds at its output a number which is proportional to the power apply to the resonator (10) according to the temperature at the imput, the fast memory (26) being addressed by signal from the counter (25) and wherein said means for altering the control of the means (21) for applying an electric excitation power comprises a digital-analog converter (27), to which output information is supplied from the fast memory (16) and an automatic gain control circuit (28) which receives the voltage signal from the digital-analog converter and controls the operating power of an excitation amplifier (21) whose output is connected to the second electrode (2).

Fig. 1

Fig. 2